# EUROPÄISCHE PATENTSCHRIFT

(11) **EP 3 246 960 B1**
(45) Veröffentlichungstag und Bekanntmachung des Hinweises auf die Patenterteilung: **24.10.2018**
(21) Anmeldenummer: 17173800.8
(22) Anmeldetag: 14.05.2013
(51) Int. Cl.: H01L 51/54, C07F 9/94

(54) **HAUPTGRUPPENMETALLKOMPLEXE ALS P-DOTANDEN FÜR ORGANISCHE ELEKTRONISCHE MATRIXMATERIALIEN**
MAIN GROUP METAL COMPLEXES AS P-DOPANTS FOR ORGANIC ELECTRONIC MATRIX MATERIALS
COMPLEXES DE MÉTAUX DES GROUPES PRINCIPAUX UTILISÉS COMME DOPANTS P POUR DES MATÉRIAUX DE MATRICES ÉLECTRONIQUES ORGANIQUES

(30) Priorität: 06.06.2012 DE 102012209523
(43) Veröffentlichungstag der Anmeldung: 22.11.2017
(62) Teilanmeldung aus: 16163380.5
(73) Patentinhaber: Siemens Aktiengesellschaft, 80333 München (DE); OSRAM OLED GmbH, 93049 Regensburg (DE)
(72) Erfinder: Maltenberger, Anna, 91359 Leutenbach (DE); Petrukhina, Marina A., Schenectady, NY New York 12303 (US); Schmid, Günter, 91334 Hemhofen (DE); Wemken, Jan Hauke, 90449 Nürnberg (DE)
(74) Vertreter: Michalski Hüttermann & Partner Patentanwälte mbB

(56) Entgegenhaltungen:
- WO-A1-2008/154915
- WO-A1-2011/033023
- EVGENY V. DIKAREV ET AL: "Tuning the Properties at Heterobimetallic Core: Mixed-Ligand Bismuth-Rhodium Paddlewheel Carboxylates", JOURNAL OF THE AMERICAN CHEMICAL SOCIETY, Bd. 128, Nr. 9, 1. März 2006 (2006-03-01), Seiten 2814-2815, XP055088058, ISSN: 0002-7863, DOI: 10.1021/ja058294h

## Beschreibung

Die Erfindung betrifft die Verwendung bi- oder polynuklearer Hauptgruppenmetallkomplexe als p-Dotanden für organisch elektronische Matrixmaterialien.

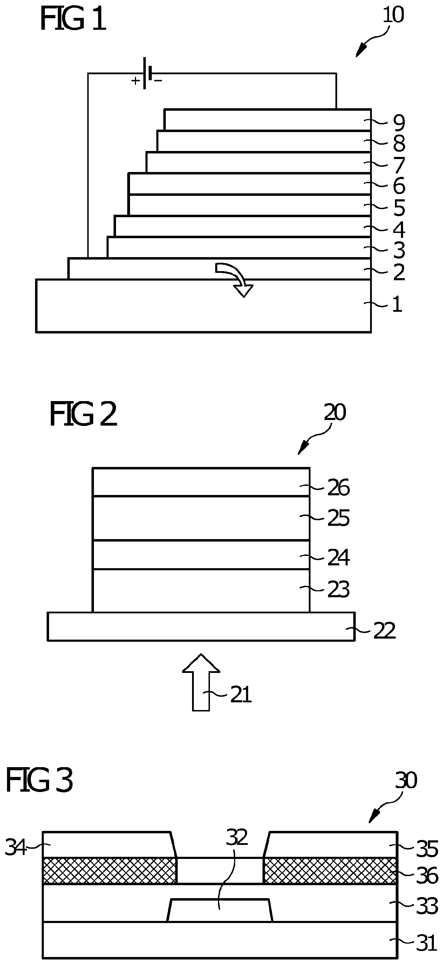

Innerhalb der organischen Elektronik lassen sich im Wesentlichen zwei wichtige kommerzielle Technologiefelder herausarbeiten. Das erste Technologiefeld beschäftigt sich dabei mit Anwendungen organischer Matrixmaterialien zur Umwandlung von Licht in elektrischen Strom und umgekehrt und das andere Feld fokussiert sich auf den Aufbau elektrischer Bauteile mittels organischem Halbleitermaterial. Beispiele für die erstgenannte Kategorie liefern zum Beispiel Fotodetektoren und organische Solarzellen, schematisch dargestellt in Figur 1, welche Licht in ein elektrisches Signal oder in elektrischen Strom umwandeln und organische Leuchtdioden (OLEDs), welche Licht mittels organischer elektronischer Materialien erzeugen können (siehe Figur 2). In den zweiten Technologiebereich fallen zum Beispiel organische Feldeffekt-Transistoren, schematisch dargestellt in Figur 3, bei denen eine Dotierung den Kontaktwiderstand zwischen Elektrode und Halbleitermaterial verringert oder bipolare Transistoren.

Allen Anwendungen ist gemein, dass sie als wesentliche, funktionale Komponente elektrische Transportschichten beinhalten, welche in Abhängigkeit ihrer Zusammensetzung unterschiedliche Leitungsmechanismen aufweisen. Allgemein unterscheidet man eine intrinsische p-(Loch)- oder eine n-(Elektronen)-Leitfähigkeit der organischen Materialien. Da die elektrischen Eigenschaften dieser organischen Substanzklassen in der Regel für eine hoch effiziente Nutzung der Bauteile unzureichend sind, werden diese mit zusätzlichen Verbindungen versetzt, welche die elektrischen Eigenschaften der Schichten verbessern sollen. Üblicherweise erfolgt dies durch Dotieren mit metallischen oder weiteren organischen Verbindungen. Ein Ansatz zur Erzielung signifikanter Verbesserungen der Leitfähigkeiten ist der Zusatz von Metallkomplexen und insbesondere der Zusatz von Übergangsmetallkomplexen.

So beschreibt zum Beispiel die WO 2005 086251 Dotanden zur Herstellung von n-leitenden Schichten, welche unter anderem auch folgende Struktur aufweisen können:

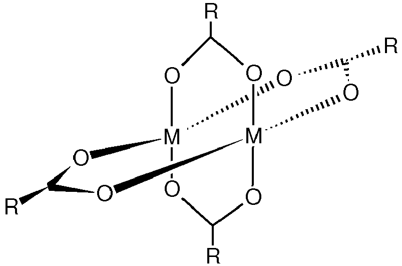

Die Struktur dieser Verbindungsklasse wird in der Literatur auch als Schaufelradkomplex "paddle wheel complex" bezeichnet. Insbesondere beschreibt die Veröffentlichung die Verwendung eines Metallkomplexes als n-Dotand zur Dotierung eines organischen halbleitenden Matrixmaterials zur Veränderung der elektrischen Eigenschaften desselben. Die vorgestellten Verbindungen sollen bezüglich des Matrixmaterials als n-Dotanden einsetzbar sein.

Einen anderen Weg unter Verwendung Lewis-saurer Metallkomplexe zur Dotierung von p-leitenden Transportschichten gibt dagegen Endo et al. (Jpn. J. Appl. Phys. Vol. 41 (2002) L358-L360) an. In dieser Literaturestelle werden organische elektrolumineszierende Vorrichtungen beschrieben, welche eine p-leitende Schicht aufweisen, die mittels einer Co-Dotierung aus FeCl3 und Arylamin-Derivaten, wie z.B. N,N'-dinapthyl-N,N-diphenyl benzidine (α-NPD), hergestellt werden. Allerdings werden dort auch signifikante Nachteile für das Bauteil, wie Löschung der Lumineszenz und Erhöhung der Eigenabsorption beschrieben.

Eine weitere Möglichkeit zu Ausgestaltung organischer Halbleiter für bipolare Transistoren durch Dotierung wird zudem in der DE 102010041331 offenbart.
Desweiteren sind mehrkernige Metallkomplexe z.B. aus der WO 2008/154915 bekannt.

Kupfermetallkomplexe mit Benzoesäure-Liganden sind bereits aus der WO 2011/033023 bekannt.

Es stellt sich jedoch die Aufgabe, weitere Materialien zu finden, welche als sich als p-Dotanden in organisch elektronische Matrixmaterialien, insbesondere Lochtransportern eignen und die Effizienz von Bauteilen enthaltend diese Schichten erhöhen.

Gelöst wird diese Aufgabe durch ein organisches elektronisches Bauteil gemäß Anspruch 1 der vorliegenden Erfindung. Demgemäß wird ein organisches elektronisches Bauteil mit einer Matrix vorgeschlagen, wobei die Matrix als p-Dotand einen Metallkomplex gemäß Anspruch 1 enthält.

Überraschend hat sich herausgestellt, dass diese Materialien als p-Dotanden für Matrixmaterialien in organischen elektronischen Bauteilen geeignet sind. Insbesondere weisen diese Materialien oftmals einen oder mehrere der folgenden Vorteile auf
- Die Materialien sind gut aus verschiedenen Quellen zusammen mit dem Matrixmaterial co-evaporierbar, so dass sich dotierte Matrixschichten definierter Zusammensetzung bilden
- Die Materialien sind auf einfachem Wege erhältlich und benötigen keine aufwendigen Herstellungsprozesse
- Die Dotierstärke ist der Matrix anpassbar
- Die Leitfähigkeit kann über die Konzentration und die Art des Stoffes eingestellt werden.
Im Sinne der vorliegenden Erfindung bedeutet und/oder umfasst die Bezeichnung "organisches elektronisches Bauteil" insbesondere organische Transistoren, organische lichtemittierende Dioden, lichtemittierende elektrochemische Zellen, organische Solarzellen, Photodioden sowie organische Photovoltaik allgemein.
Im Sinne der vorliegenden Erfindung umfasst oder bedeutet die Bezeichnung "p-Dotand" insbesondere Materialien, die eine Lewis-Acidität aufweisen und /oder in der Lage sind, Komplexe mit dem Matrixmaterial auszubilden, in denen diese Materialien (wenn auch nur formal) Lewis-acide wirken.

Ein derartiges Hauptgruppenmetallkomplex-Matrixmaterial (Lochleiter) kann z.B. die folgende Struktur haben (hier angedeutet mit Bismut als Metall und eine Koordination über den Stickstoff):

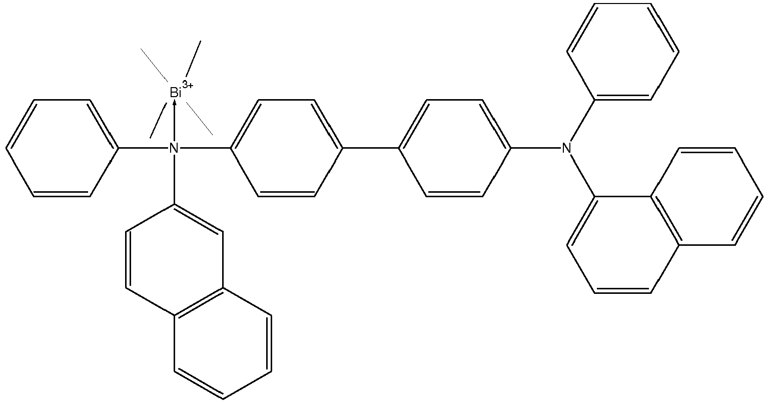

Allgemeine Gruppendefinition: Innerhalb der Beschreibung und den Ansprüchen werden allgemeine Gruppen, wie z.B: Alkyl, Alkoxy, Aryl etc. beansprucht und beschrieben. Wenn nicht anders beschrieben, werden bevorzugt die folgenden Gruppen innerhalb der allgemein beschriebenen Gruppen im Rahmen der vorliegenden Erfindung verwendet:
alkyl: lineare und verzweigte C1-C8-Alkyle,
langkettige Alkyle: lineare und verzweigte C5-C20 Alkyle
Alkenyl: C2-C6-alkenyl,
Cycloalkyl: C3-C8-cycloalkyl,
Alkoxy: C1-C6-alkoxy,
langkettig Alkoxy: lineare und verzweigte C5-C20 Alkoxy
Alkylene: ausgewählt aus der Gruppe enthaltend: methylene; 1,1-ethylene; 1,2-ethylene; 1,1-propylidene; 1,2-propylene; 1,3- propylene; 2,2-propylidene; butan-2-ol-1,4-diyl; propan-2-ol-1,3-diyl; 1, 4-butylene; cyclohexane-1,1-diyl; cyclohexan-1,2-diyl; cyclohexan-1,3- diyl; cyclohexan-1,4-diyl; cyclopentane-1,1-diyl; cyclopentan-1,2-diyl; und cyclopentan-1,3-diyl,
Aryl: ausgewählt aus Aromaten mit einem Molekulargewicht unter 300Da.
Arylene: ausgewählt aus der Gruppe enthaltend: 1,2-phenylene; 1,3- phenylene; 1,4-phenylene; 1,2-naphthylene; 1,3-naphtalenylene; 1,4- naphthylene; 2,3-naphthylene; 1-hydroxy-2,3-phenylene; 1-hydroxy-2,4-phenylene; 1-hydroxy-2,5-phenylene; und 1-hydroxy-2,6-phenylene,
Heteroaryl: ausgewählt aus der Gruppe enthaltend: pyridinyl; pyrimidinyl; pyrazinyl; triazolyl; pyridazinyl; 1,3,5-triazinyl; chinoninyl; isochinoninyl; chinoxalinyl; imidazolyl; pyrazolyl; benzimidazolyl; thiazolyl; oxazolidinyl; pyrrolyl; thiophenyl; carbazolyl; indolyl; und isoindolyl, wobei das Heteroaryl mit der Verbindung über jedes Atom im Ring des ausgewählten Heteroaryls verbunden sein kann.
Heteroarylene: ausgewählt aus der Gruppe enthaltend: pyridindiyl; quinolindiyl; pyrazodiyl; pyrazoldiyl; triazolediyl; pyrazindiyl, thiophendiyl; und imidazolediyl, wobei das heteroarylene als Brücke in der Verbindung über ein beliebiges Atom im Ring des ausgewählten Heteroaryls fungiert, speziell bevorzugt sind: pyridin-2, 3-diyl; pyridin-2,4-diyl; pyridin-2,5-diyl; pyridin-2,6-diyl; pyridin-3,4- diyl; pyridin-3,5-diyl; quinolin-2,3-diyl; quinolin-2,4-diyl; quinolin-2, 8-diyl; isoquinolin-1,3-diyl; isoquinolin-1,4-diyl; pyrazol-1,3-diyl; pyrazol-3,5- diyl; triazole-3,5-diyl; triazole-1,3-diyl; pyrazin-2,5-diyl; und imidazole-2,4-diyl, thiophen-2,5-diyl, thiophen-3,5-diyl; ein -C1-C6-heterocycloalkyl, ausgewählt aus der Gruppe enthaltend: piperidinyl; piperidine; 1,4-piperazine, tetrahydrothiophene; tetrahydrofuran; 1,4,7-triazacyclononane; 1,4,8,11- tetraazacyclotetradecane; 1,4,7,10,13-pentaazacyclopentadecane; 1,4-diaza- 7-thiacyclononane; 1,4- diaza-7-oxa-cyclononane; 1,4,7,10-tetraazacyclododecane; 1,4-dioxane; 1,4, 7-trithiacyclononane; pyrrolidine; und tetrahydropyran, wobei das Heteroaryl mit dem C1-C6-Alkyl über jedes Atom im Ring des ausgewählten Heteroaryls verbunden sein kann.
Heterocycloalkylene: ausgewählt aus der Gruppe enthaltend: piperidin-1,2-ylene; piperidin-2,6-ylene; piperidin-4,4-ylidene; 1,4-piperazin-1,4-ylene; 1,4-piperazin-2,3-ylene; 1,4-piperazin-2,5-ylene; 1,4-piperazin-2,6-ylene; 1,4-piperazin- 1,2-ylene; 1,4-piperazin-1,3-ylene; 1,4-piperazin-1,4-ylene; tetrahydrothiophen-2,5-ylene; tetrahydrothiophen-3,4-ylene; tetrahydrothiophen-2,3-ylene; tetrahydrofuran-2,5-ylene; tetrahydrofuran- 3,4-ylene; tetrahydrofuran-2,3-ylene; pyrrolidin-2,5-ylene; pyrrolidin-3,4-ylene; pyrrolidin-2,3-ylene; pyrrolidin-1,2-ylene; pyrrolidin-1,3-ylene; pyrrolidin-2,2-ylidene; 1,4,7-triazacyclonon-1,4-ylene; 1,4,7- triazacyclonon-2,3-ylene; 1,4,7-triazacyclonon-2,9-ylene; 1,4,7-triazacyclonon-3,8-ylene; 1,4,7-triazacyclonon-2,2- ylidene; 1,4,8,11-tetraazacyclotetradec-1,4-ylene; 1,4,8,11- tetra-azacyclotetradec-1,8-ylene; 1,4,8,11-tetraazacyclotetradec-2,3-ylene; 1,4,8,11-tetraazacyclotetradec-2,5-ylene; 1,4,8,11- tetraazacyclotetradec-1,2-ylene; 1,4,8,11- tetra-azacyclotetradec-2,2-ylidene; 1,4,7,10-tetraazacyclododec-1,4-ylene; 1,4,7,10-tetraazacyclododec-1,7-ylene; 1,4,7,10-tetraazacyclododec-1,2- ylene; 1,4,7,10-tetraazacyclododec-2,3- ylene; 1,4,7,10-tetraazacyclododec-2,2-ylidene; 1,4,7,10,13 pentaazacyclopentadec-1,4-ylene; 1,4,7,10,13-pentaazacyclopentadec-1,7-ylene; 1,4,7,10,13-pentaazacyclopentadec-2,3- ylene; 1,4,7,10,13-pentaazacyclopentadec-1,2-ylene; 1,4,7,10,13-pentaazacyclopentadec-2,2-ylidene; 1,4-diaza-7-thia-cyclonon-1,4-ylene; 1,4-diaza-7-thia-cyclonon-1,2-ylene; 1,4-diaza-7thia-cyclonon- 2,3-ylene; 1,4-diaza-7-thia-cyclonon-6,8-ylene; 1,4-diaza-7-thia-cyclonon- 2,2-ylidene; 1,4-diaza-7-oxacyclonon-1,4-ylene; 1,4-diaza-7-oxa-cyclonon- 1,2-ylene; 1,4diaza-7-oxa-cyclonon-2,3-ylene; 1,4-diaza-7-oxa-cyclonon-6, 8-ylene; 1,4-diaza-7-oxa-cyclonon-2,2-ylidene; 1,4-dioxan-2,3-ylene; 1,4- dioxan-2,6-ylene; 1,4-dioxan-2,2-ylidene; tetrahydropyran-2,3-ylene; tetrahydropyran-2,6-ylene; tetrahydropyran-2,5-ylene; tetrahydropyran-2,2- ylidene; 1,4,7-trithia-cyclonon-2,3-ylene; 1,4,7-trithia-cyclonon-2,9- ylene; und 1,4,7-trithia-cyclonon-2,2-ylidene,
Heterocycloalkyl: ausgewählt aus der Gruppe enthaltend: pyrrolinyl; pyrrolidinyl; morpholinyl; piperidinyl; piperazinyl; hexamethylene imine; 1,4-piperazinyl; tetrahydrothiophenyl; tetrahydrofuranyl; 1,4,7- triazacyclononanyl; 1,4,8,11-tetraazacyclotetradecanyl; 1,4,7,10,13- pentaazacyclopentadecanyl; 1,4-diaza-7-thiacyclononanyl; 1,4-diaza-7-oxa- cyclononanyl; 1,4,7,10-tetraazacyclododecanyl; 1,4-dioxanyl; 1,4,7- trithiacyclononanyl; tetrahydropyranyl; und oxazolidinyl, wobei das Heterocycloalkyl mit der Verbindung über jedes Atom im Ring des ausgewählten Heterocycloalkyls verbunden sein kann.
Amine: die Gruppe -N(R)2 wobei jedes R unabhängig ausgewählt ist aus: Wasserstoff; C1-C6-alkyl; C1-C6-alkyl-C6H5; und phenyl, wobei wenn beide R' C1-C6 alkyl sind, beide R' einen - NC3 bis NC5 heterocyclischen Ring bilden können, wobei die restliche Alkylkette einen Alkylsubstituenten am heterocyclischen Ring bildet
Halogen: ausgewählt aus der Gruppe enthaltend: F; Cl; Br und I
Halogenalkyl: ausgewählt aus der Gruppe enthaltend mono, di, tri-, poly- und perhalogenierte lineare und verzweigte C1-C8-alkyl, besonders bevorzugt -CF₃
Pseudohalogen: ausgewählt aus der Gruppe enthaltend -CN, - SCN, -OCN, N3, -CNO, -SeCN
Carboxylat: die Gruppe -C(O)OR, wobei R ausgewählt ist aus: Wasserstoff; C1-C6-alkyl; phenyl; C1-C6-alkyl-C6H5;
Carbonyl: die Gruppe -C(O)R, wobei R ausgewählt ist aus: Wasserstoff; C1-C6-alkyl; phenyl; C1-C6-alkyl-C6H5 und amine ausgewählt aus der Gruppe: -NR'2, wobei jedes R' unabhängig ausgewählt ist aus: Wasserstoff; Cl- C6-alkyl; C1-C6-alkyl-C6H5; und phenyl, wobei wenn beide R' C1-C6 alkyl sind, beide R' einen -NC3 bis NC5 heterocyclischen Ring bilden können, wobei die restliche Alkylkette einen Alkylsubstituenten am heterocyclischen Ring bildet

Soweit nicht anders erwähnt, sind die folgenden Gruppen mehr bevorzugte Gruppen innerhalb der allgemeinen Gruppendefinition :
alkyl: lineare und verzweigte C1-C6-alkyl,
langkettige Alkyle: lineare und verzweigte C5-C10 alkyl, vorzugsweise C6-C8 alkyle
alkenyl: C3-C6-alkenyl,
cycloalkyl: C6-C8-cycloalkyl,
alkoxy: Cl-C4-alkoxy,
langkettig Alkoxy: lineare und verzweigte C5-C10 alkoxy, vorzugsweise lineare C6-C8 alkoxy
Alkylene: ausgewählt aus der Gruppe enthaltend: methylene; 1,2-ethylene; 1,3-propylene; butan-2-ol-1,4-diyl; 1,4-butylene; cyclohexane-1,1-diyl; cyclohexan-1,2-diyl; cyclohexan-1,4-diyl; cyclopentane-1,1-diyl; und cyclopentan-1,2-diyl,
Aryl: ausgewählt aus der Gruppe enthaltend: phenyl; biphenyl; naphthalenyl; anthracenyl; und phenanthrenyl,
arylene: ausgewählt aus der Gruppe enthaltend: 1,2-phenylene; 1,3- phenylene; 1,4-phenylene; 1,2-naphthylene; 1,4-naphtalenylene; 2,3- naphthylene und 1-hydroxy-2,6-phenylene,
Heteroaryl: ausgewählt aus der Gruppe enthaltend: pyridinyl; pyrimidinyl; chinoninyl; pyrazolyl; triazolyl; isochinoninyl; imidazolyl; und oxazolidinyl, wobei das Heteroaryl mit der Verbindung über jedes Atom im Ring des ausgewählten Heteroaryls verbunden sein kann,
Heteroarylene: ausgewählt aus der Gruppe enthaltend: pyridin 2,3-diyl; pyridin-2,4-diyl; pyridin-2,6-diyl; pyridin-3,5-diyl; quinolin-2,3-diyl; quinolin-2,4-diyl; isoquinolin-1,3-diyl; isoquinolin-1,4-diyl; pyrazol-3,5-diyl; und imidazole-2,4-diyl,
Heterocycloalkyl: ausgewählt aus der Gruppe enthaltend: pyrrolidinyl; morpholinyl; piperidinyl; piperidinyl; 1,4 piperazinyl; tetrahydrofuranyl; 1,4,7-triazacyclononanyl; 1,4,8,11-tetraazacyclotetradecanyl; 1,4,7,10,13- pentaazacyclopentadecanyl; 1,4,7,10-tetraazacyclododecanyl; und piperazinyl, wobei das Heteroaryl mit der Verbindung über jedes Atom im Ring des ausgewählten Heteroaryls verbunden sein kann
Heterocycloalkylene: ausgewählt aus der Gruppe enthaltend: piperidin-2,6-ylene; piperidin-4,4-ylidene; 1,4-piperazin-1,4-ylene; 1,4-piperazin-2,3-ylene; 1,4-piperazin-2,6-ylene; tetrahydrothiophen-2,5-ylene; tetrahydrothiophen-3,4-ylene; tetrahydrofuran-2,5-ylene; tetrahydrofuran-3,4-ylene; pyrrolidin-2,5-ylene; pyrrolidin-2,2-ylidene; 1,4,7-triazacyclonon-1,4- ylene; 1,4,7-triazacyclonon-2,3-ylene; 1,4,7-triazacyclonon-2,2-ylidene; 1,4,8,11- tetraazacyclotetradec-1,4-ylene; 1,4,8,11- tetraazacyclotetradec-1,8-ylene; 1,4,8,11-tetraazacyclotetradec-2,3-ylene; 1,4,8,11- tetra-azacyclotetradec-2,2-ylidene; 1,4,7,10-tetraazacyclododec-1,4-ylene; 1,4,7,10- tetraazacyclododec-1,7-ylene; 1,4,7,10-tetraazacyclododec-2,3-ylene; 1,4,7,10- tetraazacyclododec-2,2-ylidene; 1,4,7,10,13- pentaazacyclopentadec-1,4-ylene; 1,4,7,10,13- pentaazacyclopentadec-1,7-ylene; 1,4-diaza-7-thia-cyclonon-1,4 ylene; 1,4-diaza-7-thia-cyclonon-2,3-ylene; 1,4-diaza-7-thiein cyclonon-2,2-ylidene; 1,4-diaza-7-oxacyclonon-1,4-ylene; 1,4 diaza-7-oxa-cyclonon-2,3-ylene;1,4-diaza-7-oxa-cyclonon-2,2- ylidene; 1,4-dioxan-2,6-ylene; 1,4-dioxan-2,2-ylidene; tetrahydropyran-2,6-ylene; tetrahydropyran-2,5-ylene; und tetrahydropyran- 2,2-ylidene, ein -C1-C6-alkyl-heterocycloalkyl, wobei das Heterocycloalkyl ausgewählt aus der Gruppe enthaltend: piperidinyl; 1,4-piperazinyl; tetrahydrofuranyl; 1,4,7- triazacyclononanyl; 1,4,8,11-tetraazacyclotetradecanyl; 1,4,7,10,13- pentaazacyclopentadecanyl; 1,4,7,10-tetraazacyclododecanyl; und pyrrolidinyl, wobei das Heterocycloalkyll mit der Verbindung über jedes Atom im Ring des ausgewählten Heterocycloalkyls verbunden sein kann
Amin: die Gruppe -N (R) 2, wobei jedes R unabhängig ausgewählt ist aus: Wasserstoff; C1-C6-alkyl; und Benzyl,
Halogen: ausgewählt aus der Gruppe enthaltend: F und Cl,
Carboxylat: die Gruppe -C(O)OR, wobei R ausgewählt ist aus Wasserstoff; C1-C6-alkyl; und benzyl,
Carbonyl: die Gruppe: -C(O)R, wobei R ausgewählt ist aus: Wasserstoff; C1-C6-alkyl; Benzyl und Amine ausgewählt aus der Gruppe: -NR'2, wobei jedes R' unabhängig ausgewählt ist aus: Wasserstoff; C1-C6-alkyl; und Benzyl,

Beispielhaft sind als Liganden L bevorzugt angeführt fluorierte Benzoesäuren wie z.B. 2-(Trifluoromethyl)benzoesäure; 3,5-Difluorobenzoesäure; 3-Hydroxy-2,4,6-triiodobenzoesäure; 3-Fluoro-4-methylbenzoesäure; 3-(Trifluoromethoxy)benzoesäure; 4-(Trifluoromethoxy)benzoesäure; 4-Chloro-2,5-difluorobenzoesäure; 2-Chloro-4,5-difluorobenzoesäure; 2,4,5-Trifluorobenzoesäure; 2-Fluorobenzoesäure; 4-Fluorobenzoesäure; 2,3,4-Trifluorobenzoesäure; 2,3,5-Trifluorobenzoesäure; 2,3-Difluorobenzoesäure; 2,4-Bis(trifluoromethyl)benzoesäure; 2,4-Difluorobenzoesäure; 2,5-Difluorobenzoesäure; 2,6-Bis(trifluoromethyl)benzoesäure; 2,6-Difluorobenzoesäure; 2-Chloro-6-fluorobenzoesäure; 2-Fluoro-4-(trifluoromethyl)benzoesäure; 2-Fluoro-5-(trifluoromethyl)benzoesäure; 2-Fluoro-6-(trifluoromethyl)benzoesäure; 3,4,5-Trifluorobenzoesäure; 3,4-Difluorobenzoesäure; 3,5-Bis(trifluoromethyl)benzoesäure; 3-(Trifluoromethyl)benzoesäure; 3-Chloro-4-fluorobenzoesäure; 3-Fluoro-5-(trifluoromethyl)benzoesäure; 3-Fluorobenzoesäure; 4-Fluoro-2-(trifluoromethyl)benzoesäure; 4-Fluoro-3-(trifluoromethyl)benzoesäure; 5-Fluoro-2-methylbenzoesäure; 2-(Trifluoromethoxy)benzoesäure; 2,3,5-Trichlorobenzoesäure; 4-(Trifluoromethyl)benzoesäure; Pentafluorobenzoesäure; 2,3,4,5-Tetrafluorobenzoesäure,
Gemäß einer alternativen bevorzugten Ausführungsform ist R³ ausgewählt aus der Gruppe enthaltend: 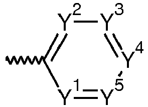 wobei Y¹ - Y⁵ unabhängig voneinander ausgewählt sind aus der Gruppe enthaltend C-F, C-CF₃ C-NO₂, C-CN, C-Halogen oder C-Pseudohalogen.
Gemäß einer bevorzugten Ausführungsform ist der Metallkomplex (ohne Anwesenheit von Matrixmaterial) lewis-sauer, d.h. er agiert als Elektronenpaarakzeptor. Dies hat sich für eine Interaktion mit den Matrixmaterialien als besonders bevorzugt herausgestellt.
Gemäß einer bevorzugten Ausführungsform besitzt der Metallkomplex (ohne Anwesenheit von Matrixmaterial) mindestens eine offene oder teilweise zugängliche Koordinationsstelle. Dies hat sich ebenfalls für eine Interaktion mit den Matrixmaterialien als besonders bevorzugt herausgestellt.
Gemäß einer bevorzugten Ausführungsform können die Verbindungen sowohl in der Gasphase, als auch der Flüssigphase verarbeitet werden. Bei der Gasphasenabscheidung werden sowohl Dotierstoff als auch Matrixmaterial gemeinsam, bevorzugt aus unterschiedlichen Quellen im Hochvakuum verdampft und als Schicht abgeschieden. Bei der Verarbeitung aus der Flüssigphase werden der Metallkomplex und das Matrixmaterial in einem Lösungsmittel gelöst und mittels Drucktechniken, Spincoating, Rakeln, Slotcoating etc. abgeschieden. Die fertige Schicht wird durch Verdampfen des Lösungsmittels erhalten. Dabei lassen sich durch die unterschiedlichen Massenverhältnisse von Metallkomplex zum Matrixmaterial beliebige Dotierungsverhältnisse einstellen.

Besonders bevorzugt lassen sich mittels eines Lösemittelprozesses folgende Lochleiter verarbeiten:

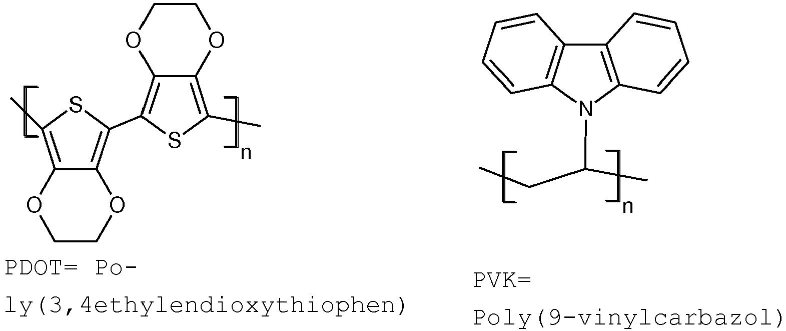

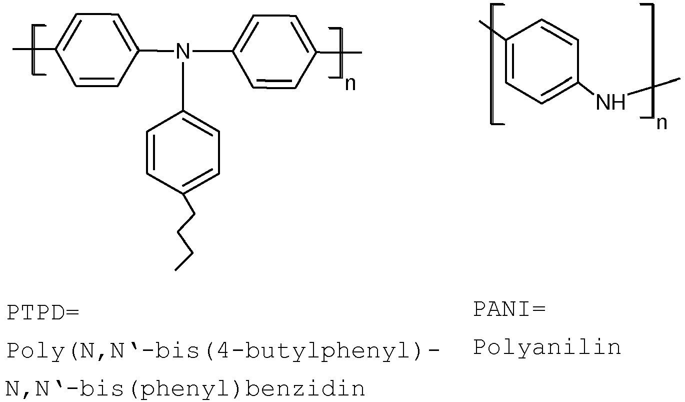

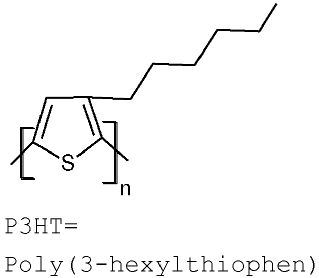

Desweiteren können sich mittels eines Lösemittelprozesses besonders bevorzugt Matrixmaterialien verarbeiten, welche als "small molecules" bezeichnet werden. Diese Substanzklasse ist dem Fachmann bekannt und darunter fallen zum Beispiel Spiro-TAD (2,2',7,7'-Tetrakis-(N,N-diphenylamino)-9,9'-spirobifluoren)und Spiro-TTB (2,2',7,7'-Tetrakis-(N,N'-di-p-methylphenylamino)-9,9'-spirobifluoren und weitere Materialien wie sie in dieser Anmeldung als Matrixmaterialien aufgeführt sind.

Gemäß einer bevorzugten Ausführungsform ist der Metallkomplex ein mono- oder bi- oder polynuklearer Metallkomplex. Insbesondere kann der Metallkomplex im Festkörper als polynuklearer Metallkomplex vorliegen. Der im Festkörper poly-nukleare Metallkomplex kann während der Verdampfung de-polymerisieren und kann vorteilshafterweise in der Gasphase mono-nuklear vorliegen. Diese Ausführungsform ist besonders vorteilhaft, da so eine besonders innige Durchmischung und gute Bindung der Komplexe an die Matrixmaterialien erfolgt.

Gemäß einer bevorzugten Ausführungsform ist mindestens einer der Liganden L zwischen zwei Metallen verbrückend angeordnet.

Gemäß einer bevorzugten Ausführungsform besitzt der Metallkomplex die Summenformel M₂L₄, (mit M = Metall und L = Ligand), wobei sowohl die Metalle wie die einzelnen Liganden unabhängig voneinander gemäß der obigen Definition ausgewählt sein können.

Gemäß einer weiteren bevorzugten Ausführungsform kann der Metallkomplex das Metallatom M Sn oder Bismut enthalten. Besonders bevorzugt können die Metallkomplexe nach unten angegebenen Strukturen entweder ein-kernig 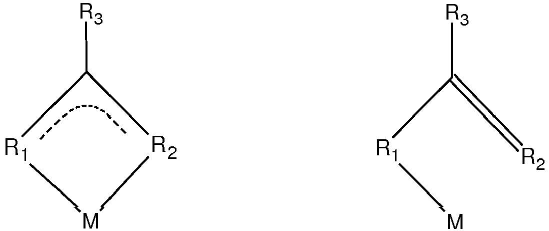 oder nach weiter unten angegebenen Strukturen zwei-kernig aufgebaut sein:

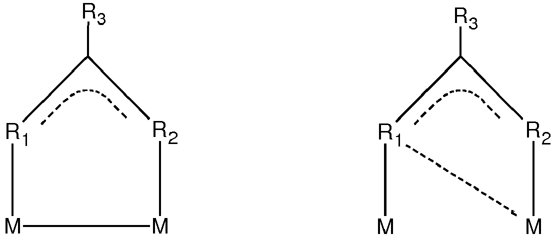

Ohne durch die Theorie gebunden zu sein ergibt sich bei den ein-kernigen Komplexen eine terminale Koordination des Metalls über den/die Liganden. Im Falle eines zwei-kernigen Komplexes ergibt sich eine zwei- oder drei-zähnige Koordination des Metallatoms. Werden zum Aufbau eines zwei-zähnigen Komplexes unterschiedliche Metallatome herangezogen ergibt sich ein hetero-bimetallischer Komplex.

Besonders bevorzugt enthält der Hauptgruppenmetallkomplex Bismut. Hierbei sind besonders bevorzugt Bismut-Hauptgruppenmetallkomplexe:
Der Oxidationsstufen II, welcher ohne durch die Theorie gebunden als Funktion der gewählten Liganden folgende paddle-wheel-Struktur aufweisen können.

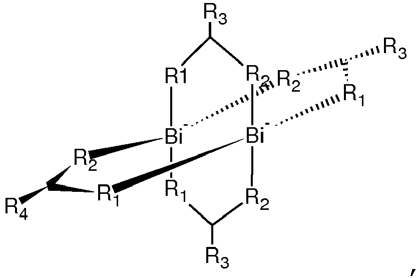

Der Oxidationsstufe III (MLₙ = 3), welche ohne durch die Theorie gebunden zu sein keine paddle-wheel-Struktur aufweisen. Diese Verbindungen liegen in der Regel Festkörper mono- bis poly-nuklear vor und können während des Verdampfungsprozesses depolymerisieren.

Der Oxidationsstufe V, in welcher in einer besonderen Ausführungsform der Hauptgruppenmetallkomplex Bismut der Oxidationsstufe V mit folgendem Aufbau enthalten sei kann:

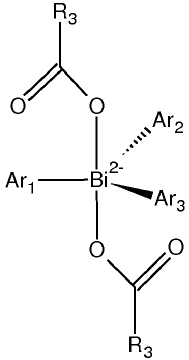

Die Arᵢ können in diesem bevorzugten Falle unabhängig voneinander aus der Gruppe der substituierten oder unsubstituierten Aromaten oder Heteroaromaten ausgewählt sein. In einer besonderen Ausführungsform handelt es sich um partiell oder perfluorierte Aromaten oder Heteroaromaten. Desweiteren besonders bevorzugt können die Arᵢ ausgewählt werden aus der Gruppe der nicht-fluorierten oder fluorierten Carboxylate oder allgemein aus der Gruppe der Liganden L, wie sie in dieser Anmeldung aufgeführt sind.

Gemäß einer alternativen Ausführungsform besitzt der Metallkomplex die Struktur MLₘ, mit M = Metall, L = Ligand und m = 1 bis 10, wobei wenn m > 1 alle L unabhängig voneinander sind. Diese Metallkomplexe sind insbesondere bei Zinn und Bismut bevorzugt; in diesem Fall ist m bevorzugt m = 2 für Zinn bzw. 2, 4, und 3 oder 5 für Bismut, je nach Oxidationsstufe.

Gemäß einer alternativen Ausführungsform der Erfindung ist besitzt der Metallkomplex die Struktur ML₂L'ₙ, mit M = Metall, L = Ligand, wie oben definiert und L' = ein zu L nicht identischer Ligand ausgewählt aus der Gruppe Aryl, Heteroaryl, Halogenaryl und Halogenheteroaryl, wobei n von 0 bis 3 betragen kann und für den Fall, dass n > 1 ist, jedes L' unabhängig von den anderen ausgewählt ist. Diese Metallkomplexe sind insbesondere bei Zinn und Bismut bevorzugt; in diesem Fall ist n = 2 für Zinn bzw. 1 oder 3 für Bismut, je nach Oxidationsstufe sowie n = 0 bevorzugt.

Gemäß einer bevorzugten Ausführungsform umfasst das Matrixmaterial des opto-elektronischen Bauteils eines oder mehrere der folgenden Materialien:
NPB (N,N'-Bis(naphthalen-1-yl)-N,N'-bis(phenyl)-benzidin),
β-NPB N,N'-Bis(naphthalen-2-yl)-N,N'-bis(phenyl)-benzidin) TPD (N,N'-Bis(3-methylphenyl)-N,N'-bis(phenyl)-benzidin) Spiro TPD (N,N'-Bis(3-methylphenyl)-N,N'-bis(phenyl)-benzidin)
Spiro-NPB (N,N'-Bis(naphthalen-1-yl)-N,N'-bis(phenyl)-spiro)
DMFL-TPD N,N'-Bis(3-methylphenyl)-N,N'-bis(phenyl)-9,9-dimethyl-fluoren)
DMFL-NPB (N,N'-Bis(naphthalen-1-yl)-N,N'-bis(phenyl)-9,9-dimethyl-fluoren)
DPFL-TPD (N,N'-Bis(3-methylphenyl)-N,N'-bis(phenyl)-9,9-diphenyl-fluoren)
DPFL-NPB (N,N'-Bis(naphthalen-1-yl)-N,N'-bis(phenyl)-9,9-diphenyl-fluoren)
Spiro-TAD (2,2',7,7'-Tetrakis(n,n-diphenylamino)- 9,9 '-spirobifluoren)
9,9-Bis[4-(N,N-bis-biphenyl-4-yl-amino)phenyl]-9H-fluoren
9,9-Bis[4-(N,N-bis-naphthalen-2-yl-amino)phenyl]-9H-fluoren
9,9-Bis[4-(N,N'-bis-naphthalen-2-yl-N,N'-bis-phenyl-amino)-phenyl]-9H-fluoren
N,N'-bis (phenanthren-9-yl)-N,N'-bis (phenyl)-benzidin
2,7-Bis[N,N-bis(9,9-spiro-bifluorene-2-yl)-amino]-9,9-spiro-bifluoren
2,2'-Bis[N,N-bis(biphenyl-4-yl)amino]9,9-spiro-bifluoren
2,2'-Bis(N,N-di-phenyl-amino)9,9-spiro-bifluoren
Di-[4-(N,N-ditolyl-amino)-phenyl]cyclohexan
2,2',7,7'-tetra(N, N-di-tolyl)amino-spiro-bifluoren
N, N,N',N'-tetra-naphthalen-2-yl-benzidin
Spiro-TTB (2,2',7,7'-Tetrakis-(N,N'-di-p-methylphenylamino)-9,9'-spirobifluoren).

Diese Materialien haben sich als Matrixmaterialien in (opto)-elektronischen Bauteilen bewährt.

Gemäß einer bevorzugten Ausführungsform der Erfindung beträgt der Dotierungsgrad in mol Metallkomplex bezogen auf mol Matrixmaterial von ≥0,1% bis ≤50%. Dies hat sich als zweckmäßig herausgestellt. Bevorzugt beträgt der Dotierungsgrad von ≥0,5% bis ≤15%, noch bevorzugt ≥1% bis ≤5%.

Besonders bevorzugte partielle oder perfluorierte Liganden L werden ausgewählt aus substituierten oder unsubstituierten Verbindungen Benzoesäure und sind beispielhaft oben angeführt. In einer weiteren bevorzugten Ausführungsform können ein oder mehrere mehrzähnige Liganden L verbrückend zwischen den Metallatomen des Komplexes angeordnet sein.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können. Weitere Einzelheiten, Merkmale und Vorteile des Gegenstandes der Erfindung ergeben sich aus den Unteransprüchen sowie aus der nachfolgenden Beschreibung der Figuren und der zugehörigen Beispiele. In den Figuren zeigt:
Fig. 1 schematisch den Aufbau einer organischen Leuchtdiode (10). Die Leuchtdiode ist aufgebaut aus einer Glas-Schicht (1); Transparent Conductive oxide (TCO)- oder PEDOT:PPS- oder PANI-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); Elektronen-Injektorschicht (8)und einer Kathoden-Schicht (9) ;
Fig. 2 schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
Fig. 3 schematisch einen möglichen Querschnitt eines organischen Feld-Effekt-Transistors (30). Auf einem Substrat (31) ist eine Gate-Elektrode (32), ein Gate-Dielektrikum (33), eine Source and Drain-Kontakt (34 + 35) und ein organischer Halbleiter (36) aufgebracht. Die schraffierten Stellen zeigen die Stellen an denen eine Kontaktdotierung hilfreich ist.
Fig. 4 die Stromdichte gegen die Spannung für ein undotiertes Matrixmaterial sowie für ein dotiertes Matrixmaterial (nicht erfindungsgemäß);
Fig. 5 die Absorption gegen die Wellenlänge für die Materialien aus Fig. 4;
Fig. 6 die Photolumineszenz gegen die Wellenlänge für die Materialien aus Fig. 4
Fig. 7 die Reflektion gegen die Wellenlänge für das dotierte Material aus Fig. 4
Fig. 8 die Stromdichte gegen die Spannung für ein undotiertes Matrixmaterial sowie für mehrere dotierte Matrixmaterialien gemäß einer zweiten Ausführungsform der Erfindung;
Fig. 9 die Absorption gegen die Wellenlänge für die Materialien aus Fig. 8;
Fig. 10 die Photolumineszenz gegen die Wellenlänge für die dotierten Materialien aus Fig. 8
Fig. 11 die Reflektion gegen die Wellenlänge für die Materialien aus Fig. 8
Fig. 12 die Stromdichte gegen die Spannung für ein undotiertes Matrixmaterial sowie für mehrere dotierte Matrixmaterialien gemäß einer dritten Ausführungsform der Erfindung;
Fig. 13 die Stromdichte gegen die Spannung für ein undotiertes Matrixmaterial sowie für mehrere dotierte Matrixmaterialien gemäß einer vierten Ausführungsform der Erfindung;
Fig. 14 die Stromdichte gegen die Spannung für ein undotiertes Matrixmaterial sowie für mehrere dotierte Matrixmaterialien gemäß einer fünften Ausführungsform der Erfindung;
Fig. 15 die Lumineszenz gegen die Spannung für die dotierten Materialien aus Fig. 14;
Fig. 16 die Stromdichte gegen die Spannung für ein undotiertes Matrixmaterial sowie für mehrere dotierte Matrixmaterialien gemäß einer sechsten Ausführungsform der Erfindung;
Fig. 17 die Lumineszenz gegen die Spannung für die dotierten Materialien aus Fig. 16;

### Beispiel I

### (nicht erfindungsgemäß)

Beispiel I bezieht sich auf Bi(O₂CCF₃)₃, welches gemäß Literatur hergestellt wurde, s. Bo Li "Heterometallic Carboxylates Incorperating Bismuth", PhD Thesis State University of New York at Albany, Chair M. Petrukhina 2007, UMI Number 3277252 sowie Vera Reiland "Chemie und Koordinationschemie von Bismuttrifluoracetat und verwandten Verbindungen", Dissertation D368, Universität Kaiserslautern 2000.

### Verdampfung

ITO-vorstrukturierte Glassubstrate wurden 10 min. einer Sauerstoffplasmabehandlung unterzogen und dann anschließend so schnell als möglich in den Verdampfer überführt. Der Verdampfer wurde in eine Argon-Glovebox überführt, in der die Sauerstoff- und Wasserkonzentration weniger als 2ppm beträgt.

Alle Verdampfungen wurden bei einem Vakuum von weniger als 2 x 10⁻⁶ mbar Basisdruck durchgeführt (bei der Verdampfung steigt der Druck dann an).

Zunächst wurden sowohl Matrix- wie Dotiermaterial bis kurz vor den Verdampfungspunkt erhitzt, anschließend wurde solange erhitzt, bis eine konstante Verdampfung beobachtet werden konnte.

Die gesamte Verdampfungsrate war ungefähr 1 Ǻ/s, wobei die Verdampfungsrate des Dotiermaterials über die Verdampfungsrate des Matrixmaterials eingestellt wurde.

Nachdem die Shutter geschlossen waren, wurde auf 40°C abgekühlt, mit Argon geflutet, die Maske für die Abscheidung der Kathode gewechselt und anschließend wieder evakuiert.

Die Elektrode bestand aus einer 150nm dicken Schicht Aluminium, welche mit einer anfänglichen Verdampfungsrate von 0,5 Ǻ/s, welche langsam auf 5 Ǻ/s gesteigert wurde, aufgebracht wurde.

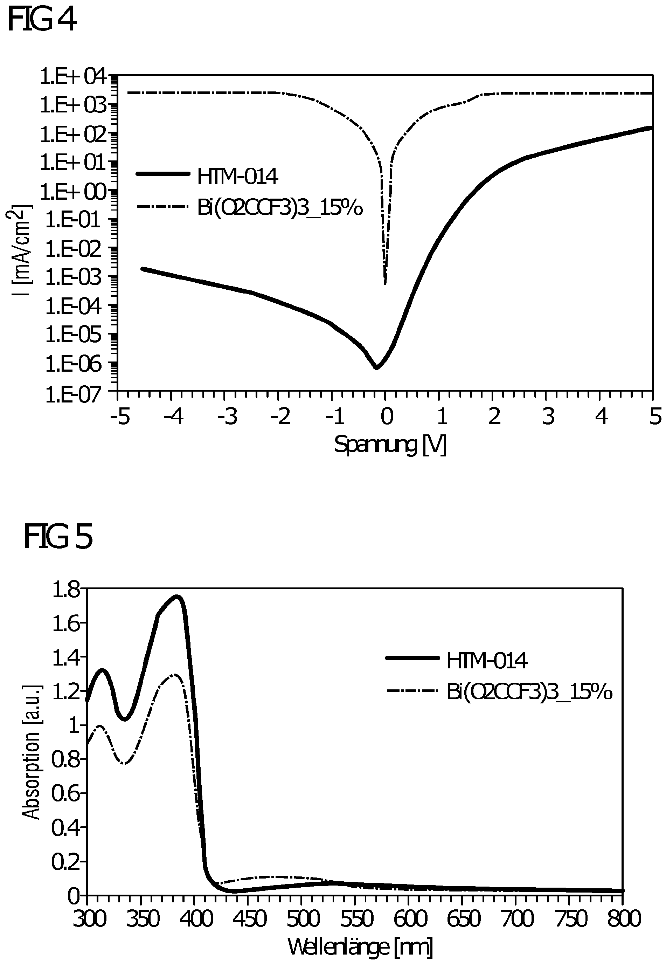

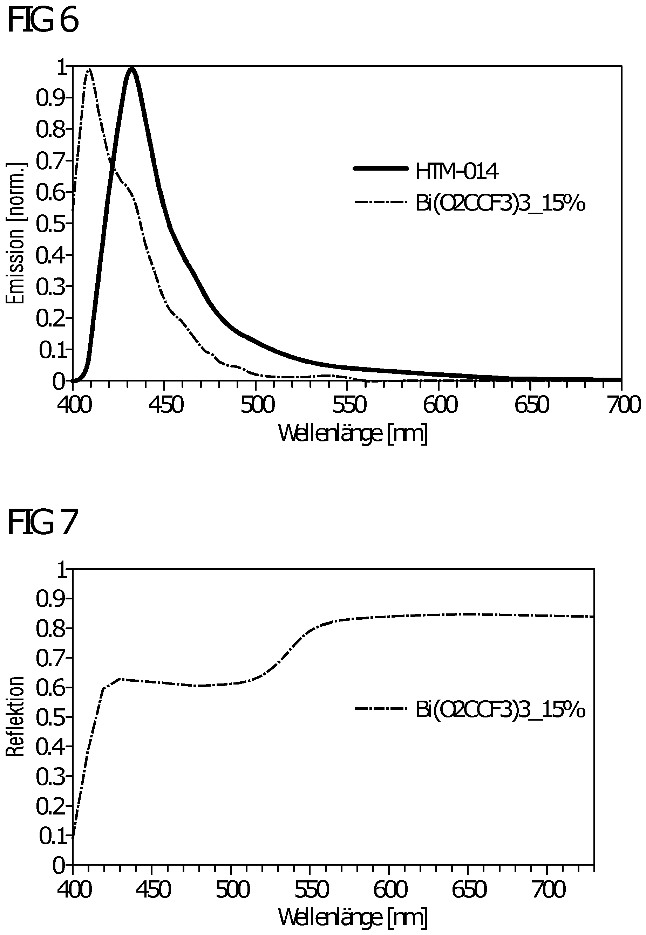

Die Figuren 4 bis 7 beziehen sich auf mit Bi(O₂CCF₃)₃ dotiertes sowie undotiertes HTM-014 (Matrixmaterial, Fa. Merck KGaA). Dabei wurden jeweils 200 nm dicke Schichten von HTM-014 (Merck KGaA) einerseits sowie mit 15% Bi(O₂CCF₃)₃ dotiertes HTM-014 andererseits hergestellt.

Fig. 4 zeigt die Stromdichte gegen die angelegte Spannung für die beiden Materialien. Man sieht schon bei der dotierten Schicht eine Erhöhung der Stromdichte gegen die angelegte Spannung.

Zur Untersuchung der optischen Eigenschaften des erfindungsgemäßen Dotiermaterials wurden die Absorption, die Photolumineszenz und die Reflektion gemessen (Figuren 5 bis 7). Man sieht, dass die Komplexe nahezu transparent sind, was sie geeignet für einen Einsatz in (opto)-elektronischen Bauteilen macht.

### Beispiel II:

Beispiel II bezieht sich auf Bi(O₂CC₆H₂(2,3,4-F₃))₃, welches folgendermaßen hergestellt wurde:
Ein 50ml Schlenkkolben wurde mit 0,251 g (0.57mmol) Triphenylbismuth (III) gefüllt, anschließend wurde mit 10-15 ml frisch destilliertem Benzol aufgefüllt und mit einem Überschuss (ca. 3 mmol) 2,3,4-Trifluorbenzoesäure versetzt. Die Mischung wird eine Stunde unter Rückfluss erhitzt und dann auf Raumtemperatur abgekühlt, anschließend wird mit Unterdruck das Lösemittel abgezogen, bis ein weißer Feststoff ausfällt. Das Rohprodukt (Ausbeute 85-88%) wird mit wenig Hexan gewaschen und über Nacht im Vakuum getrocknet. Zur Reinigung kann sublimiert werden.

In Analogie zu Beispiel I wurden vier Schichten, einmal bestehend aus einem undotierten Matrixmaterial (HTM-014, Fa. Merck) sowie mit 5%, 13% und 15% Bi(O₂CC₆H₂(2,3,4-F₃))₃ dotierten Schichten HTM-014 aufgebracht. Die Schichtdicke war jeweils 200nm.

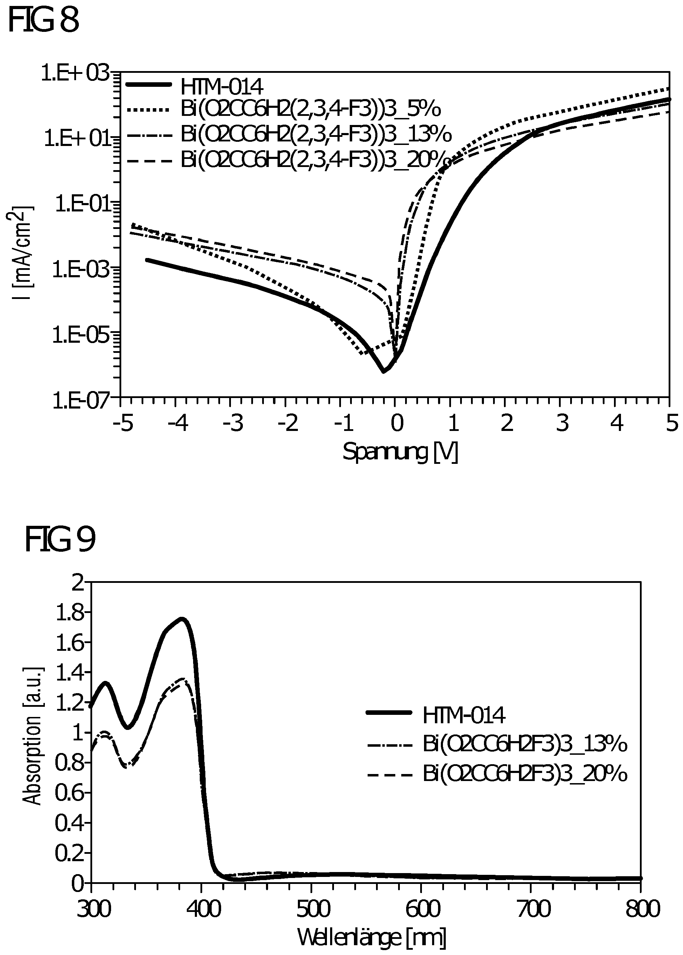

Fig. 8 zeigt die Stromdichte gegen die angelegte Spannung für die drei Materialien. Man sieht schon bei der 5% dotierten Schicht eine Erhöhung der Stromdichte gegen die angelegte Spannung.

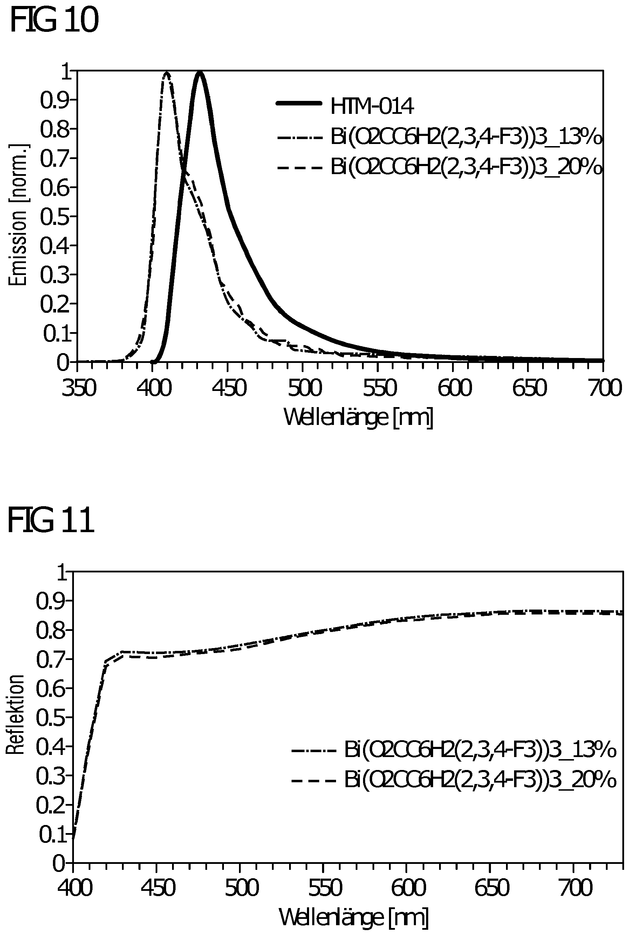

Zur Untersuchung der optischen Eigenschaften des erfindungsgemäßen Dotiermaterials wurden die Absorption, die Photolumineszenz und die Reflektion gemessen (Figuren 9 bis 11). Man sieht, dass die Komplexe nahezu transparent sind, was sie geeignet für einen Einsatz in (opto)-elektronischen Bauteilen macht.

### Beispiel III:

Im Rahmen eines Lösemittelprozesses wird ein Majoritätsladungsträgerbauelement hergestellt, wobei als polymerer Lochleiter HIL-012 (Matrixmaterial, Fa. Merck KGaA) und als Dotierungsmittel die Metallkomplexe Bi(O₂C₂F₃)₃ (nicht erfindungsgemäß) und BipFbz verwendet werden.

Zur Herstellung eines undotierten Lochleiters wird eine 2 Gew.%-Lösung des HIL-012 in Anisol und Xylol (Volumenverhältnis der Lösemittel 1:1) mittels eines Spincoaters auf eine ITO-beschichtete Glasplatte aufgebracht. Das Aufbringen erfolgt für 40 s mit einer Schleuderdrehzahl von 1200 upm (Umdrehungen pro Minute) und nach 1 h trocknen bei 120 °C (Normaldruck) wird eine 120 nm dicke Schicht HIL-012 erhalten. Für die obere Elektrode wird mittels eines Vakuum-Verdampfungsverfahrens eine 200 nm dicke Aluminiumschicht aufgebracht.

Die Herstellung der mit den erfindungsgemäßen Metallkomplexen dotierten Schichten erfolgt analog, mit der Ausnahme, dass die mit den Dotierstoffen Bismut-tris-trifluoroacetat Bi(O₂C₂F₃)₃ bzw. Bismut-tris-pentafluorobenzoat (BipFBz) versetzten Lösungen verarbeitet werden. Der Gesamtfeststoffanteil beträgt bei diesen Ausführungsformen insgesamt 2 Gew.% und der Anteil der Dotanden am Gesamtfeststoffanteil beträgt 15 Gew.%.

Die Parameter für das Spincoating ergeben sich zu 1500 upm für das Element mit Bi(O₂C₂F₃)₃ als Dotand und 1000 upm für das Element mit BipFBz. Insgesamt wird für eine Zeitdauer von 40 s beschichtet und die Schichtdicke nach Trocknung unter den oben genannten Parametern beträgt 100 nm für beide Elemente.

Die Messungen erfolgen jeweils an 4 mm² großen Elementen.

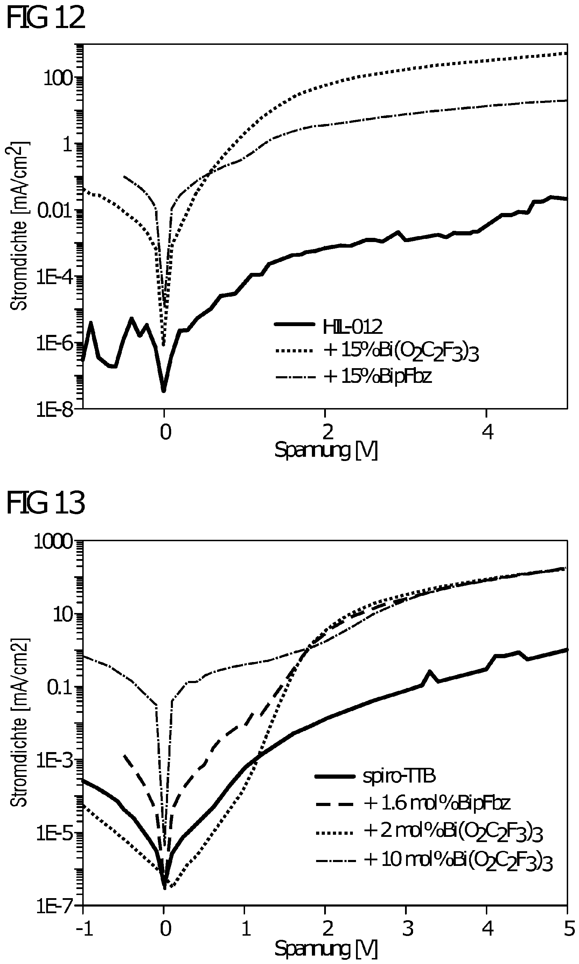

Die Fig. 12 zeigt die erhaltenen Stromdichte-Spannungskennlinien für die unterschiedlichen Bauelemente dieses Beispiels. Es lässt sich deutlich feststellen, dass durch die Dotierung eine um mehrere Größenordnungen erhöhte Leitfähigkeit resultiert.

### Beispiel IV:

Im Rahmen eines Lösemittelprozesses wird ein Majoritätsladungsträgerbauelement hergestellt, wobei als polymerer Lochleiter spiro-TTB und als Dotierungsmittel die Metallkomplexe Bi(O₂C₂F₃)₃ (nicht erfindungsgemäß) und BipFbz verwendet werden.

Die Verarbeitung der Dotierstoffe mit dem "small molecule" Lochleitermaterial spiro-TTB erfolgt in analoger Weise zum Beispiel III. Für die Herstellung von 100 nm dicken Schichten werden insgesamt 3,5 Gew.% Lösungen herstellt (Anisol:Xylol Lösungsmittelgemisch Verhältnis 1:2), welche 1,6 mol%, 2 mol % und 10 mol% Dotierstoff bezogen auf die Menge an Matrixmaterial enthalten. Die Lösungen werden mit 750 upm für 40s aufgeschleudert und bei 120°C für 1 h getrocknet.

Die Fig. 13 zeigt die erhaltenen Stromdichte-Spannungskennlinien für die unterschiedlichen Bauelemente dieses Beispiels. Durch die Dotierung lässt sich wiederum eine sehr deutliche Erhöhung der Leitfähigkeit gegenüber dem reinen Lochleitermaterial erreichen. Es zeigt sich zudem, dass ca. 10 mol% an Dotierung notwendig sind, um einen ausreichenden Einfluss auf die Leitfähigkeit zu erzielen.

### Beispiel V:

Die in Beispiel III beschriebenen undotierten und dotierten Lochleiterschichten werden in rote OLEDs eingebaut. Die roten OLEDs besitzen folgende Schichtstruktur Glas/ITO/100nm HTL variiert/10nm NPB/20 nm Emitterschicht aus 20%NPB, 70% TPBi, 10% ADS076/60nm TPBi/0,7nm LiF/ 200nm Al.

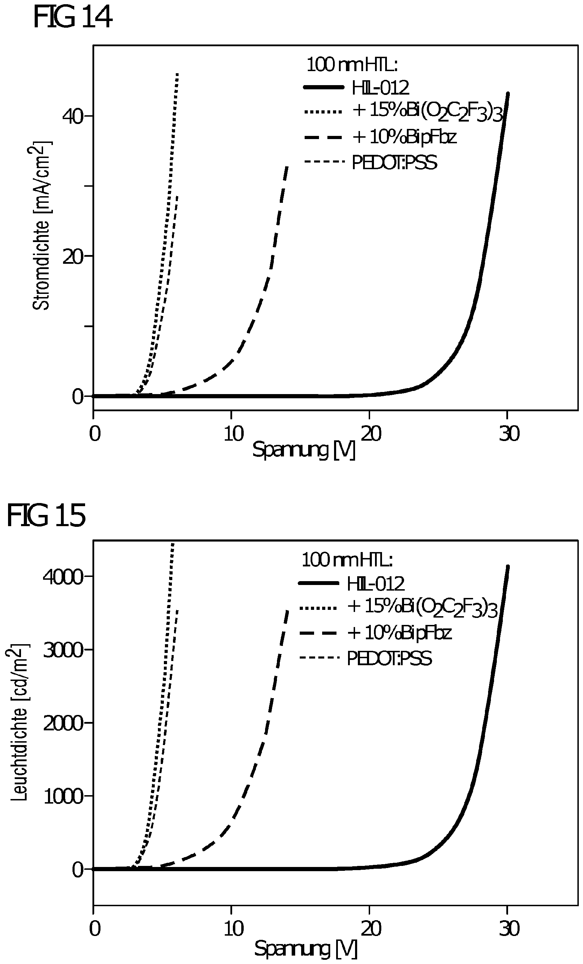

Als Dotierstoffe werden Bismut-tris-trifluoroacetat Bi(O₂C₂F₃)₃ (nicht erfindungsgemäß) und Bismut-tris-pentafluorobenzoat(BipFBz) in den in Fig. 14 und Fig. 15 angegebenen Konzentrationen eingesetzt. Es zeigt sich, dass die mittels Lösemittelprozess erhaltenen, erfindungsgemäßen OLEDs bezüglich der Leuchtdichte (Fig. 15) und der Strom-Spannungskennlinie (Fig. 14) besser sind als Referenz-OLEDs mit PEDOT-PSS.

### Beispiel VI:

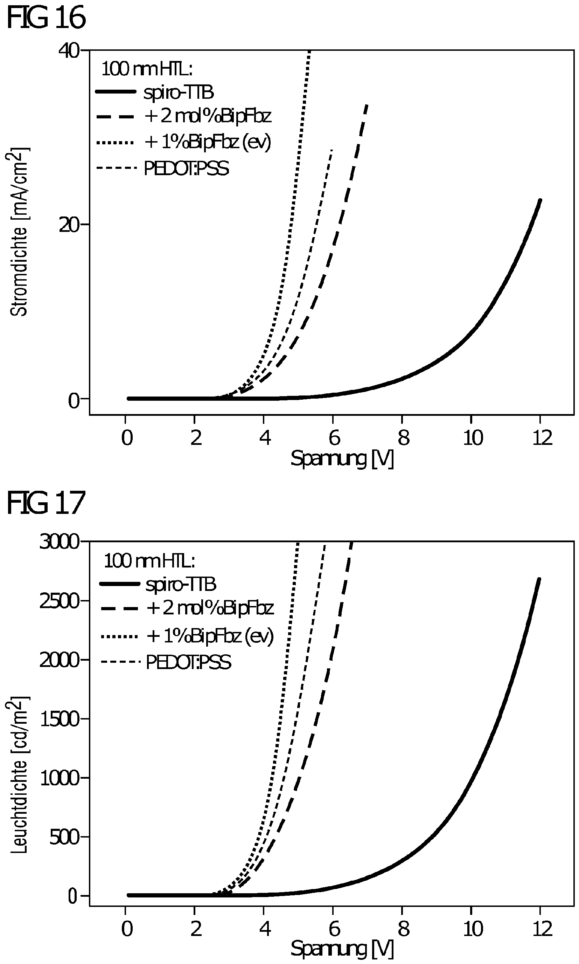

Anstelle der HIL-012 basierten HIL aus Beispiel V wird Spiro-TTB als Lochleiter benutzt und mit BipFBz dotiert. Spiro-TTB und BipFBz lassen sich dabei sowohl nach dem Lösemittel-(Kennlinienbezeichnung BipFBz) als auch nach dem Verdampfungsverfahren (Kennlinienbezeichnung BipFBz (ev)) herstellen. Die charakteristischen Stromdichte-Spannungs-Kennlinie bzw. Luminanz-Spannungskennlinie sind in den Figuren 16 und 17 abgebildet. Es zeigt sich, dass die Eigenschaften von nach dem Verdampfungsverfahren hergestellter Schichten besser sind als die aus Lösung abgeschiedener. Die Differenzen sind jedoch gering.

### Beispiel VII:

Die in den Beispielen III und IV hergestellten, dotierten Lochleiterschichten können auch als Lochleiterschichten für organische Solarzellen, insbesondere diejenigen mit p-i-n Struktur, genutzt werden.

## Patentansprüche

1. Organisches elektronisches Bauteil mit einer Matrix, wobei die Matrix als p-Dotand einen Metallkomplex mit zumindest einem partiell- oder perfluoriertem Liganden der folgenden Struktur enthält: 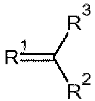 mit R1 = R2 = Sauerstoff, wobei der Ligand eine substituierte oder unsubstituierte Verbindung der Benzoesäure ist und **dadurch gekennzeichnet, dass** das Metall ausgewählt ist aus der Gruppe enthaltend Bismut, Zinn oder Mischungen daraus.

2. Organisches elektronisches Bauteil nach Anspruch 1, wobei das Metall Bismut ist und der Ligand aus einer Gruppe ausgewählt ist, die 3,5-Bis(trifluoromethyl)benzoesäure; 3-(Trifluoromethyl)benzoesäure, 3,5-Difluorobenzoesäure und Pentafluorobenzoesäure umfasst.

3. Organisches elektronisches Bauteil nach Anspruch 1 bis 2, wobei der Dotierungsgrad in mol Metallkomplex bezogen auf mol Matrixmaterial von ≥ 0,1 % bis ≤ 50 % beträgt.

4. Organisches elektronisches Bauteil nach Anspruch 1 bis 2, wobei der Dotierungsgrad in mol Metallkomplex bezogen auf mol Matrixmaterial von ≥ 0,5 % bis ≤ 15 % beträgt.

5. Organisches elektronisches Bauteil nach Anspruch 1 bis 2, wobei der Dotierungsgrad in mol Metallkomplex bezogen auf mol Matrixmaterial von ≥ 1 % bis ≤ 5 % beträgt.

## Claims

1. An organic electronic component having a matrix, wherein the matrix contains, as p-dopant, a metal complex containing at least a partially or per-fluorinated ligand of the following structure 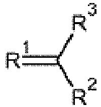 wherein R¹ = R² = oxygen and wherein the ligand is a substituted or unsubstituted benzoic acid, **characterized in that** the metal is selected from the group containing bismuth, tin or mixtures thereof.

2. The organic electronic component according to claim 1, wherein the metal is bismuth and the ligand is selected from the group comprising 3,5-bis(trifluoromethyl)benzoic acid, 3-(trifluoromethyl)benzoic acid, 3,5-difluorobenzoic acid and pentafluorobenzoic acid.

3. The organic electronic component according to any one of claims 1 to 2, wherein the doping level in mol of metal complex based on mol of matrix material is from ≥ 0.1% to ≤ 50%.

4. The organic electronic component according to any one of claims 1 to 2, wherein the doping level in mol of metal complex based on mol of matrix material is from ≥ 0.5% to ≤ 15%.

5. The organic electronic component according to any one of claims 1 to 2, wherein the doping level in mol of metal complex based on mol of matrix material is from ≥ 1% to ≤ 5%.

## Revendications

1. Composant électronique organique doté d'une matrice, où la matrice contient en tant que dopant p un complexe métallique avec au moins un groupe coordonné partiellement fluoré ou perfluoré selon la structure suivante : 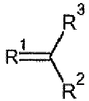 avec R¹ = R² = oxygène, où le groupe coordonné est un composé substitué ou non substitué de l'acide benzoïque et **caractérisé en ce que** le métal est choisi dans le groupe contenant du bismuth, de l'étain ou des mélanges de ceux-ci.

2. Composant électronique organique selon la revendication 1, dans lequel le métal est du bismuth et le groupe coordonné est choisi dans un groupe comprenant l'acide 3,5-bis(trifluorométhyl)benzoïque ; l'acide 3-(trifluorométhyl)benzoïque, l'acide 3,5-difluorobenzoïque et l'acide pentafluorobenzoïque.

3. Composant électronique organique selon la revendication 1 à 2, dans lequel le degré de dopage en complexe métallique en moles par rapport au matériau de la matrice en moles est ≥ 0,1 % à ≤ 50 %.

4. Composant électronique organique selon la revendication 1 à 2, dans lequel le degré de dopage en complexe métallique en moles par rapport au matériau de la matrice en moles est ≥ 0,5 % à ≤ 15 %.

5. Composant électronique organique selon la revendication 1 à 2, dans lequel le degré de dopage en complexe métallique en moles par rapport au matériau de la matrice en moles est ≥ 1 % à ≤ 5 %.
